Europäisches Patentamt

European Patent Office

Office européen des brevets

(11) Publication number: 0 399 386
A2

# EUROPEAN PATENT APPLICATION

(21) Application number: 90109406.0

(22) Date of filing: 18.05.90

(51) Int. Cl.⁵: H03H 21/00

(30) Priority: 25.05.89 US 356738

(43) Date of publication of application:
28.11.90 Bulletin 90/48

(84) Designated Contracting States:
DE FR GB IT SE

(71) Applicant: HUGHES AIRCRAFT COMPANY
7200 Hughes Terrace
Los Angeles, CA 90045-0066(US)

(72) Inventor: Beierle, Robert T.
20980 Gold Run Drive
Diamond Bar, California 91765(US)
Inventor: Veronda, Daniel R.
1644 Fairgreen Drive
Fullerton, California 92633(US)

(74) Representative: Witte, Alexander, Dr.-Ing.
Augustenstrasse 7
D-7000 Stuttgart 1(DE)

(54) Adaptive analysis apparatus.

(57) Disclosed is an adaptive analysis apparatus having a signal channel adapted to sense an acoustic signal of interest which includes noise and also having a plurality of reference channels adapted to sense such noise correlated with the noise on the signal channel. In the adaptive canceler of the apparatus, a pipelined approach is used wherein the reference signals are divided into two or more sections having concurrent weight adjustment. This architecture allows the speed of adaptive cancellation to be increased and/or the number of reference taps to be increased without loss of cancellation speed. Once a continuous stream of digital data has been established in this architecture, the speed of the adaptive processor is limited only by approximately the processing time of the slowest element. In the preferred embodiment of the adaptive analysis apparatus, the noise canceled signal is converted to the frequency domain in a Fast Fourier Transform device. A central processing unit (36) provides automatic analysis of the digital spectrum of the noise canceled signal based on a comparative analysis with predetermined reference data (66, 68, 70, 72) using statistical analysis criteria. In one embodiment, this reference data (66, 68, 70, 72) will be based on the prior analysis of a statistically sufficient sample of known devices under noise conditions similar to the noise conditions when the actual real-time analysis is to be performed.

Fig 9.

# ADAPTIVE ANALYSIS APPARATUS

## BACKGROUND

The present invention relates generally to adaptive noise suppression and, more particularly, to adaptive noise cancellation processing and comparative analysis for operating equipments or machinery. The invention relates especially to such apparatus which performs such adaptive cancellation processing and comparative analysis continuously in real time.

Although conventional performance measurements may provide an indication of defects or potential defects in operating equipments of machinery, typically only gross or catastrophic defects will be identified. Relatively few latent defects are discovered by such measurements. However, the acoustic signals emanating from an operating apparatus (acoustic signature) may contain information which identifies not only the present defects which could be found by performance measurements but also latent defects or potential defects which could lead to subsequent failures of the apparatus. Acoustic-frequency signals radiated from operating apparatus, for example apparatus having moving parts, can contain valuable information with respect to the present and future performance of the apparatus.

However, the acoustical analysis of operating components can be a difficult task. Background noise at acoustic-frequencies can mask the acoustical signals radiated from the component being examined. In the testing of a component in a factory environment for example, noise from test-stand machinery, noise from other components under test, and ambient factory noise may obscure the signals of interest radiating from the component under test. It may be possible to isolate the desired acoustical signatures using sound intensity techniques; however, in an environment where speed of analysis is important, an unacceptable amount of time is required to perform an acoustic intensity analysis due to the large number of measurements necessary to achieve sufficient accuracy. In cases where the background noise varies greatly or is unpredictable, sound intensity techniques will generally be unsatisfactory. Isolating and analyzing the acoustical signature of operating equipment is, in general, a difficult problem in any situation where an uncontrolled operating environment exists or where large amounts of interfering signals are present.

U.S. Patent No. 4,658,426 entitled "Adaptive Noise Suppression" issued to Chabries et al. suggests that adaptive processing can be used to diminish the adverse effects of noise distortion in processing signals from machinery wherein the desired signal provides an indicia of wear or malfunction. The basic theory of adaptive noise cancellation is well known and has been described by Bernard Widrow et al. in the article "Adaptive Noise Cancelling: Principle and Applications", Proceedings of the IEEE, Vol. 63, No. 12, December 1975, pages 1692-1716. In particular, Widrow et al. describe a generalized multiple-reference noise canceler on pages 1710-1711. In adaptive noise canceling, a signal channel and at least one reference channel are needed to provide noise cancellation. The signal channel receives a signal of interest which is corrupted by additive noise or interference. The reference channels receive noise that is correlated in some way with the additive noise or interference on the signal channel but not substantially correlated with the signal of interest. The signals which are received by the reference channels are adaptively filtered and then subtracted from the signal received by the signal channel to obtain an estimate of the signal of interest.

However, the successful application of adaptive noise cancellation to the analysis of a dynamically changing acoustic signature of apparatus operating in an environment contaminated with dynamically changing background noise has proven difficult to achieve. The adaptive processor must be able to respond to background noise which may vary widely in amplitude, frequency, and duration. Similarly, the acoustic signal of interest may vary widely in amplitude, frequency and duration. The noise signals may be very similar to the signal of interest. These obstacles facing the cancellation apparatus are especially troublesome if the processing and analysis is required to be done in real time.

Consider the case where it is desired to perform acoustic signature analysis on automotive transmissions as part of end-of-the-line quality control testing in a factory environment. The background noise may be the entire range of factory noises including any acoustic interference generated by the test fixture itself for the transmission under test and identical test fixtures for performing simultaneous testing on other transmissions. This may include the acoustic signals generated by the other transmissions undergoing test or other acoustic signals generated by the transmission under test itself. If the test is to be performed on every transmission, the entire test procedure, including acceptance or rejection of the part, must be accomplished very quickly in order to maintain the speed of the assembly line, for example in 20-30 seconds. Acoustic analysis of the transmission may be required at several different rotational speeds or revolutions-per-minute (RPM's). In one test configuration, the transmission is driven continuously from rest to the maximum test RPM and back to rest during the allotted time. The adaptive canceler apparatus must be able to provide the acoustic signal of interest for selected RPM's and must be able to capture this signal as the operating speed of the transmission passes through the selected RPM's. In terms of the frequency domain in the case of an automotive transmission, the acoustic signals of interest may vary from 10 Hz to 5 kHz and may be have a bandwidth as narrow as a few Hertz or as wide as thousands of Hertz. In the time domain, the frequencies of interest may vary from 100 milliseconds to 200 microseconds in duration. The interfering noise signals may present an even larger variation in signals to be processed. The analysis of other devices may present even more stringent requirements.

To satisfy the foregoing requirements, the adaptive canceler must be able to perform continuous real-time cancellation of widely varying background noise at very high data rates over a broad spectrum of frequencies and signal durations. The background noise may be such that multiple reference channels are required for satisfactory cancellation. In a typical situation, after the background noise has been canceled and the canceler is providing a continuous stream of real-time data corresponding to the signal of interest, it is desirable to provide real-time analysis of the data. Automatic analysis of the data is preferred, or even required as is the case in a production line test of a device such as an automatic transmission, or in situations where it is important that the analysis be accomplished quickly or almost instantaneously. The adaptive canceler and the automatic analysis system must have a throughput rate capable of handling the great volume of data produced in these circumstances.

## SUMMARY OF THE INVENTION

It is therefore an object of the present invention to provide for analysis of signals emanating from an apparatus operating in an environment containing noise.

Another object is to provide for continuous real-time analysis of the signals emanating from an apparatus operating in an environment containing noise.

Still another object is to provide continuous real-time adaptive analysis of the acoustic signature of apparatus operating in an environment containing noise.

Another object is to provide for acoustic analysis of operating machinery under test in a factory environment or in an operational environment.

A further object is to provide real-time continuous cancellation of interfering signals to enable the real-time detection and/or analysis of a signal or signals of interest obscured by the interfering signals.

Another object is to provide continuous cancellation of interfering signals to enable the detection and/or analysis of an acoustic signal of interest of apparatus operating in an environment contaminated by background noise.

These objects are attained by the invention wherein there is provided an adaptive analysis apparatus having a signal channel adapted to sense an acoustic signal of interest which includes corrupting interference or noise and also having a plurality of reference channels adapted to sense such corrupting noise which is correlated with the corrupting interference or noise on the signal channel but not correlated with the signal of interest.

In the invention, a distributed pipelined approach is used wherein the reference signals are divided into two or more sections having concurrent weight adjustment. This architecture provides increased processing speed over that of prior nondistributed cancelers. The use of concurrent adaptive filtering allows the speed of adaptive cancellation to be increased and/or the number of degrees of freedom (that is, the number of reference taps times the number of references) of the adaptive filter to be increased without loss of cancellation speed. The signals received in the signal channel and the reference channels are adjusted in amplitude and filtered to optimize the adaptive cancellation process and then converted to digital signals for digital adaptive cancellation.

With the concurrent processing architecture of the invention, once a continuous stream of digital data has been established, the speed of the adaptive processor is limited only by approximately the processing time of the slowest element.

The output of the adaptive canceler, which is a continuous stream of digital words from which the correlated interference has been canceled, is directly available for time-domain signal analysis in its digital form or may be converted to analog form for analysis. In the preferred embodiment of the adaptive analysis apparatus, the noise canceled signal is converted to the frequency domain in a fast Fourier transform device. A central processing unit provides automatic analysis of the digital spectrum of the noise canceled signal based on comparisons with predetermined reference data using standard statistical analysis criteria. In one embodiment, this reference data will be gathered from prior analyses of a statistically sufficient quantity of known samples of the signals of interest under noise conditions similar to the noise conditions when the actual real-time analysis is to be performed.

## BRIEF DESCRIPTION OF THE DRAWINGS

The features and advantages of the present invention may be more readily understood with reference to the following detailed description when taken in conjunction with the accompanying drawings wherein:

FIG. 1 is a schematic representation of an adaptive analysis apparatus connected for providing real-time signal analysis for end-of-the-line testing of an automotive transmission;

FIG. 2 is a high-level block diagram of an adaptive analysis apparatus according to the present invention;

FIG. 3 is a block diagram illustrating the signal conditioning circuitry of an embodiment of the adaptive analysis apparatus in accordance with the invention;

FIGS. 4 and 5 are block diagrams, which taken together, illustrate the distributed pipeline architecture of an adaptive canceler according to the present invention;

FIG. 6 is a high-level physical interconnection diagram illustrating an embodiment of an adaptive canceler in accordance with the invention;

FIG. 7 is a block diagram illustrating the data path of the adaptive canceler of FIG. 6;

FIG. 8 is a diagram illustrating the distributed architecture of a four-channel adaptive canceler in accordance with the principles of the invention;

FIG. 9 is a block diagram illustrating a central processing unit usable in an embodiment in accordance with the invention; and

FIG. 10 is a high-level process flowchart implemented in the CPU of an embodiment of the adaptive processing apparatus in accordance with the invention.

## DETAILED DESCRIPTION OF THE PREFERRED EMBODIMENTS

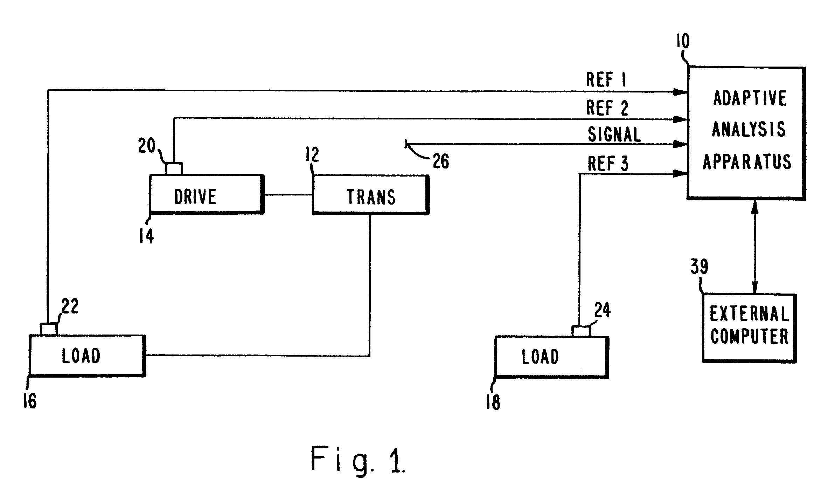

Referring now to the drawings wherein like reference numerals designate like or similar parts in the several figures, FIG. 1 schematically illustrates an adaptive analysis apparatus 10 connected for providing real-time adaptive signal analysis for end-of-the-line quality control testing of an automotive transmission 12, a setting that illustrates one of the many areas where the adaptive analysis apparatus of the invention may be employed. The transmission 12 is coupled to a drive dynamometer 14 for driving the transmission 12 at appropriate speeds for testing. The transmission 12 is also coupled to two load dynamometers 16 and 18 for applying appropriate loads to the transmission. Reference accelerometers 20, 22 and 24 are coupled to dynamometers 14, 16, and 18, respectively, for sensing vibrational energy generated by the dynamometers and other acoustic-frequency signals (such as background noise from other test fixtures or the production line in general) which may be coupled to the dynamometers. A signal microphone 26 is disposed in proximity to the transmission 12 for sensing the acoustic-frequency signals generated by the transmission (the signals of interest). This microphone 26 will also sense corrupting background noise from the dynamometers and elsewhere. The microphone 26 is not attached to the transmission 12 in this example because of the time and complexity involved in attaching and removing a sensor in the context of production-line testing. In this embodiment, a microphone and accelerometers are disclosed in a particular configuration; however, this is not meant to be restrictive of the invention. In another embodiment, accelerometers may be used exclusively, or microphones may be used exclusively, or a different combination of the two types of sensors may be used, or other types of sensors may be used, depending upon the application.

The outputs of the reference accelerometers 20, 22, and 24 and the output of the microphone 26 are coupled to the adaptive analysis apparatus 10 for adaptive cancellation of the correlated acoustic-frequency signals (noise) from the acoustic signal picked up by the microphone 26 and for automatic analysis of the resulting noise canceled signal.

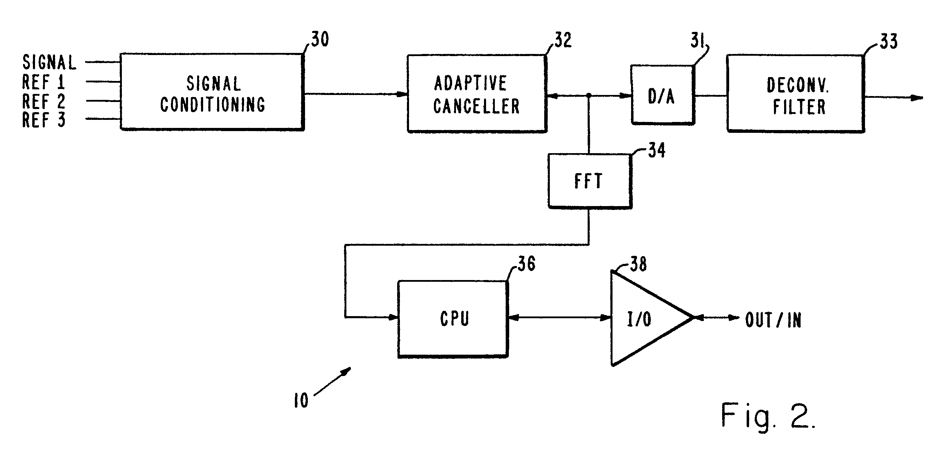

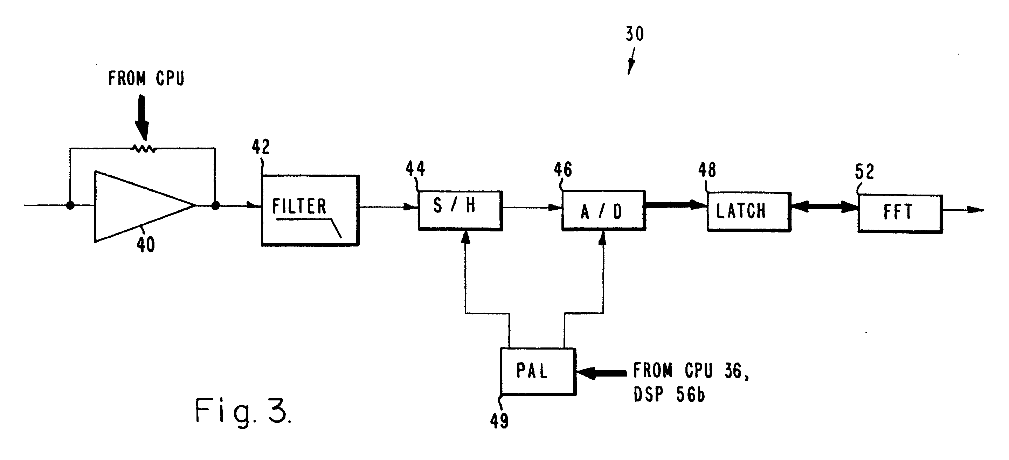

Fig. 2 is a high level block diagram which illustrates the general architecture of an adaptive analysis apparatus 10 according to the invention. The preferred embodiment of the adaptive analysis apparatus 10 has a self-contained architecture in which a signal conditioning section 30 receives a signal input from a primary sensor (such as microphone 26) on a signal channel and a plurality of reference inputs from a plurality of reference sensors (such as accelerometers 20, 22, and 24) on a plurality of reference channels. As is well known, a signal input and at least one reference input are required for adaptive noise cancellation. In adaptive cancellation, only correlated signals are canceled from the signal channel so that any signals sensed by one of the reference channels will not have any effect unless the reference signal is correlated in some way with the signals received in the signal channel. The number of reference channels need not be limited, however, as long as there is sufficient isolation between every reference channel and the signal of interest on the signal channel to prevent correlation between the signal of interest and the signals sensed by the reference channel. The signal conditioning section 30, a single channel of a preferred implementation of which is described in more detail in Fig. 3 hereinafter, conditions and digitizes the primary sensor input signal and the reference input signals in order to optimize the operation of an adaptive cancellation section 32. In general terms, the signal conditioning section 30 functions to amplify, filter, sample and digitize the analog signals coupled from the sensors.

The primary sensor signal and reference sensor signals digitized in the signal conditioning section 30 are coupled to the adaptive cancellation section 32. The adaptive cancellation section 32, as will be described more fully hereinafter, adaptively cancels the reference noise signals from the primary sensor signal in order to increase the signal-to-noise ratio of the signal of interest sensed by the primary sensor.

The output of the adaptive canceler section 32 is the signal of interest in a continuous stream of digital words. This stream of digital words (also referred to hereinafter as the noise canceled signal since the corrupting background signals have been canceled) is available for analysis. The noise canceled signal can be analyzed in its digital form in the time domain or the frequency domain through further digital processing or it can be converted back to an analog signal in a digital-to-analog converter 31 in combination with a deconvolution filter 33 for analysis. The type of analysis will be determined by the setting in which the adaptive processing apparatus is used.

Frequency-domain analysis of the noise canceled signal is often desirable and may be the preferred type of analysis in the factory test setting. For frequency-domain analysis, the noise canceled digital signal is coupled to a Fast Fourier Transform device 34 which transforms the noise canceled signal from the time domain to the frequency domain by generating a digital spectrum of the acoustic signal of interest. The digital spectrum is coupled to a central processing unit 36 which is adapted to process this digital spectrum and compare the spectral distribution to predefined spectral templates that are indicative of the spectral acoustic distribution expected for the signal of interest.

The templates may define an acceptable spectrum, an unacceptable spectrum or both. In the case where operating machinery is being analyzed, the templates generally comprise threshold values at each spectral frequency in the spectral distribution or power or energy averages over a band of frequencies, or combinations of spectral and band level measures, or other statistical measures which define the limits of noise associated with properly operating, nondefective machinery, but the templates may also define conditions indicating a latent defect, for example. The comparison may be performed under differing test conditions, such as different rotational speeds, for example, if the machine undergoing test has rotating parts. In general the characteristics of the device under test and the total circumstances of the test will define the type of comparisons that are appropriate. The central processing unit 36 analyzes the compared spectral distributions to evaluate whether the machinery has potential defects, and provides an indication of the results of the comparison through appropriate output devices such as visual displays or audio signals or an output bus interface to another computer.

Alternatively, time-domain processing of the signal of interest may be employed on the digital signals provided by the adaptive canceler 32. The central processing unit 36 may process time-domain signals and analyze them by integrating them over time and comparing the integrated signals to thresholds indicative of a properly operating machine. In addition, digital signals may be further processed in the central processing unit 36, or in a separate processor, to provide ordered data that may be comparatively analyzed by the central processing unit to determine status of the apparatus undergoing test.

The comparative analysis of the noise-canceled signal is preferably performed on a statistical basis. The basic reference data for evaluating a canceled signal of interest will typically be determined from prior analysis of a statistically sufficient sample of the signals of interest under conditions similar to the conditions when the actual real-time analysis is to be performed. The signal of interest will be analyzed using the adaptive analysis apparatus 10 to establish reference data indicating an acceptable mean and an acceptable deviation from the mean for the relevant characteristics of the signal. For example, a selected quantity of identical parts which are known to be acceptable may be analyzed. Also, a selected quantity of identical parts which are known to have defects are analyzed. In this way, a library of reference data is established for use in analyzing unknown parts. The reference data may be related to any number of characteristics of the adaptively-filtered signal such as its frequency spectrum, power distribution, total average power, or a combination of these or other selected criteria that can be obtained by signal analysis.

In one embodiment, the comparative analysis decisions are based on multiple test and statistical variation using standard statistical processing schemes. For example, templates may be provided which are based on average performance plus and minus a multiple of the standard deviation.

An interface circuit 38 is coupled between the central processing unit 36 and an external computer 39 (as shown in Fig. 1), such as a personal computer. This interface circuitry 38 provides a data path over which the central processing unit 36 may be programmed with templates for signals of interest. In addition, the interface circuit 38 provides a means for the system 10 to communicate with or even control other equipment (not shown). For example, this other equipment may effect removal of a defective piece of machinery to a rework station or forward an acceptable piece of machinery to the next station in the manufacturing process based on the comparative analysis.

Referring now to FIG. 3, a preferred implementation of the signal conditioning section 30 is shown. The implementation of Fig. 3 was employed in an embodiment of an adaptive processing apparatus 10. Although only one channel is shown in FIG. 3, the embodiment has four sensor channels - one signal channel and three reference channels. The embodiment apparatus 10 was designed for analysis of a signal of interest having a bandwidth from approximately 10 Hz to 10 kHz. In order to satisfy the well-known Nyquist criteria, this approximate 10 kHz bandwidth of interest requires that the signal be sampled at approximately twice (at least) the bandwidth or 20 kHz in this application. The signal conditioning circuit 30 comprises four substantially identical channels, each of which includes a digitally-programmable preamplifier 40 having a programmable gain, an anti-aliasing filter 42, a sample-and-hold circuit 44, an analog-to-digital converter circuit 46, and a buffer latch 48. In this embodiment, the digitally programmable preamplifiers 40, the sample-and-hold circuits 44 and the analog-to-digital converters 46 are Models AD526, AD356 and AD7572, respectively, manufactured by Analog Devices. The buffer latches 48 are model 74ALS244, manufactured by Texas Instruments. The operation (timing) of the sample-and-hold circuits 44 and the analog-to-digital converters are under the control of the central processing unit 36 through a Programmable Array Logic (PAL) 49.

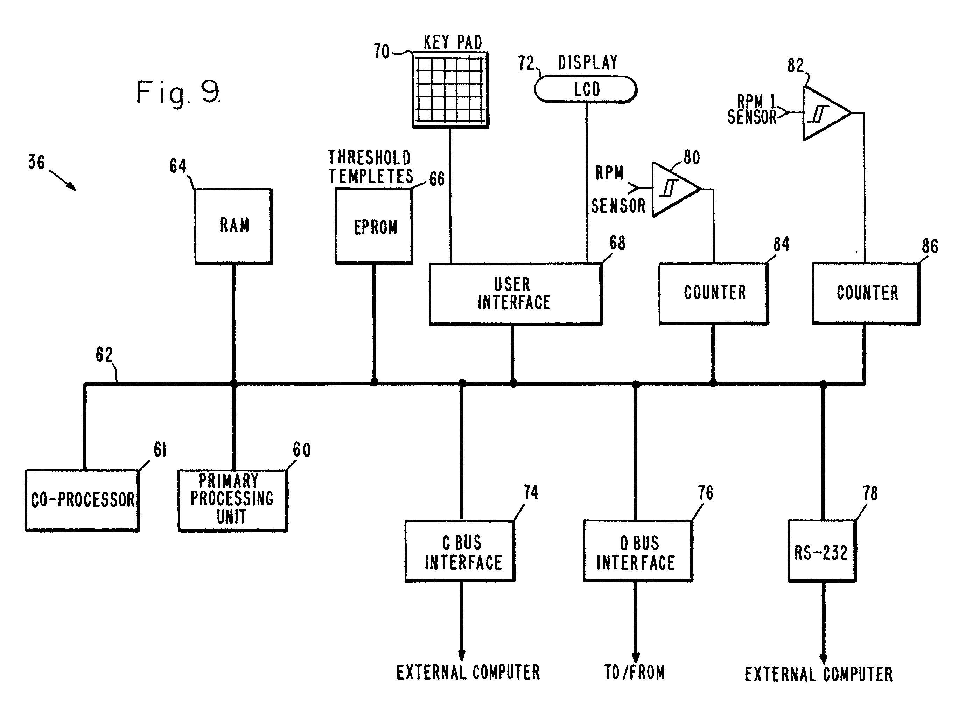

It was found that the adaptive cancellation performs better when the signal input and the reference input(s) are approximately the same amplitude due to limitations of digital gain in the canceler section. Therefore, use of the digitally-programmable preamplifier 40 permits adjustment of the amplitude of input signals (from the sensors) for optimum cancellation and further allows the amplifier gain to be adjusted through the central processing unit 36 under operator control (See Fig. 9). Another means of providing this control is through the use of an automatic gain control (AGC) circuit applied to each preamplifier. It should be noted that the adaptive processing apparatus 10 can be used with any sensor that provides an output signal in the frequency range suitable for processing by the signal conditioning section 30.

The anti-aliasing filter 42 is, in this embodiment, a conventional Butterworth filter having a minimum of four poles and having a 10 KHz roll-off corresponding to the bandwidth of interest. As is well known, increasing the number of poles in this pre-cancellation filter 42 will improve the operation of the canceler, but it will also increase complexity of the filter. Eventually a point will be reached where the improvement in cancellation will not merit the required increase in complexity in the filter.

It should be noted that the design of the reference channels and the placement of the sensors should not produce phase distortion or delay that is sufficient to cause the reference channel signals to be decorrelated relative to the primary channel signal.

The adaptive analysis apparatus 10 can be modified to operate at a larger bandwidth if the sampling rate and the anti-aliasing filter are correspondingly changed. Signals of different frequencies (including signals above acoustic-frequencies) can be analyzed if the input signals to the adaptive analysis apparatus 10 are frequency-shifted to the operating frequency of the adaptive analysis apparatus 10.

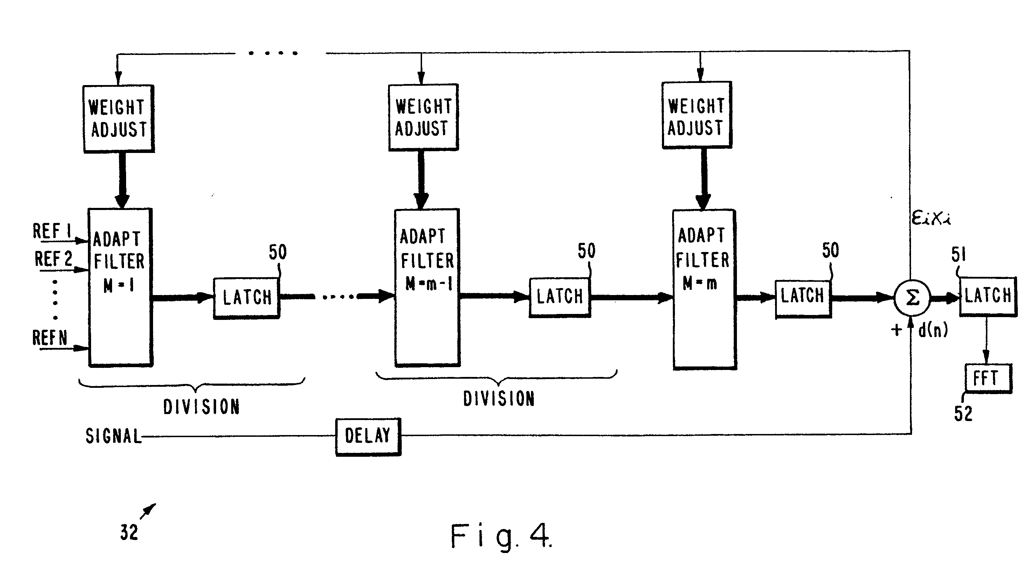

The adaptive canceler section 32 is illustrated in Figs. 4, 5, 6, 7, and 8. The so-called Least Means Square (LMS) algorithm is the preferred adaptive algorithm to control the operation of the adaptive canceler 32. See Bernard Widrow et al. "Adaptive Noise Cancelling: Principle and Applications", Proceedings of the IEEE, Vol. 63, No. 12, December 1975, pages 1707-1709 for a description of the LMS algorithm. The adaptive canceler 32 obtains improved throughput of adaptively processed data by using a distributed processing architecture to establish a pipelined processing flow. The distributed canceler architecture of the present invention can provide a large number of taps and a large number of degrees of freedom while at the same time allowing increased throughput over prior cancelers. The architecture can be expanded to increase throughput to an almost unlimited extent and/or to dramatically reduce the adaptive cancellation time over prior cancelers. The architecture is not limited to use with LMS algorithms but is applicable, in general, to implementing any adaptive processing algorithm, such as for example a recursive LMS. The architecture can be used to increase the processing speed and/or the number of degrees of freedom of the adaptive filter while providing whatever processing speed is required, the speed being limited only by approximately the processing time of the slowest element.

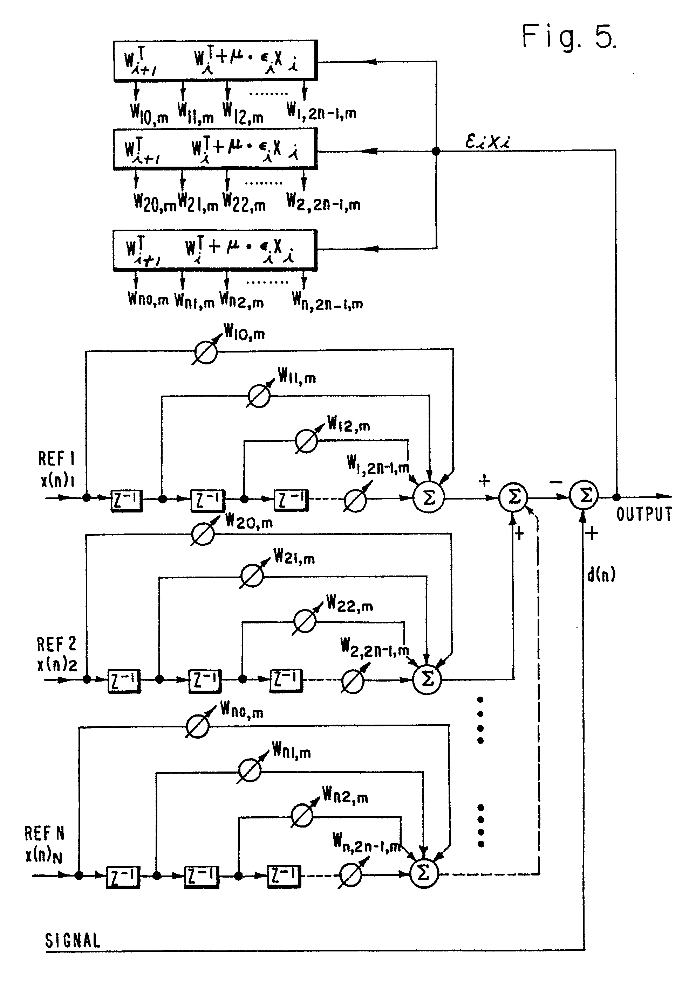

Referring now to Figs. 4 and 5, there is shown a schematic block diagram of a multiple-reference-channel (reference channels 1 through N), multiple-tap (T represents the total number of taps) LMS adaptive canceler 32 having an architecture according to the present invention. Fig. 4 schematically illustrates the overall processing architecture. In the present invention, each reference channel of T taps is divided into a plurality of divisions (divisions 1 through M) so that each division has T/M taps. It will be recognized that the divisions, 1 through M, may have differing numbers of taps per division without departing from the concept of the present invention, but an equal number of taps per division is in general the preferred approach for most efficient processing.

Fig. 5 schematically illustrates the recurring basic structure of the processing architecture of each division M. As illustrated in Fig. 5 which shows the Mth division, each of the M divisions is an adaptive filter having multiple reference channels, 1 through N, that provides at its output a signal that has been weighted T/M times since it was received at the input of the division. Each division, 1-M, implements a conventional multiple-reference-channel adaptive filter. The T/Mth weight value and the T/Mth sample data (at the output of the division) are coupled to a pipeline buffer latch 50 and then are input to the next division where the next T/M weight values are applied to the output of the previous division. It can be seen that under this architecture, the adaptive filtering (application of T/M weights) is accomplished concurrently in each of the M divisions. The output of the Mth division is then applied to an output buffer latch 51. Thus the architecture of the present invention establishes a pipeline of adaptively filtered data from the input to division M = 1, to the weighted data appearing on the output buffer latch 51 following division M. The adaptive processing time for N reference channels having a total of T taps, is effectively the time to process T/M taps in a conventional architecture. The speed of the buffer latches 50 and 51, being inherently very much greater than that of the adaptive filters 1-M, allows the processed data to be transferred from the adaptive filters so that processing is not delayed. In general, the latches in the preferred embodiment facilitate the pipeline architecture of the present invention by reducing the processing delay that occurs when a faster operating device must wait for an input from a slower operating device.

The digital data appearing on the output buffer latch 51 is a continuous stream of real-time, time-domain, adaptively-filtered data that corresponds to the acoustic signature of interest. This real-time data is available for analysis. This analysis may be accomplished in the time domain or in the frequency domain as previously noted. Considering time-domain analysis first, the adaptive canceler 32 is providing a continuous stream of digital signals which may be coupled directly from the output buffer latch 51 to the input of a digital computer. The computer may process the time domain signals and analyze them by integrating them over time and comparing the integrated signals to threshold values indicating a characteristic or value of interest. The time domain signals may be used to generate ordered data and this ordered data may be comparatively analyzed by the computer according to a predefined template.

For frequency-domain analysis the adaptive canceler output is coupled by way of the latch 51 to a conventional Fourier transform filter circuit 52. The Fourier transform filter circuit 52 is adapted to perform an N-point complex Fourier transform on the input digital signals provided by the adaptive canceler 32 to provide a spectral distribution of the signal of interest. The output of the Fourier transform filter circuit 52 may be sampled at an overlap to further increase the effective data rate of the adaptive analysis apparatus. For example, sampling the output of the filter circuit 52 at a 50 percent overlap effectively doubles the rate at which data is available for analysis.

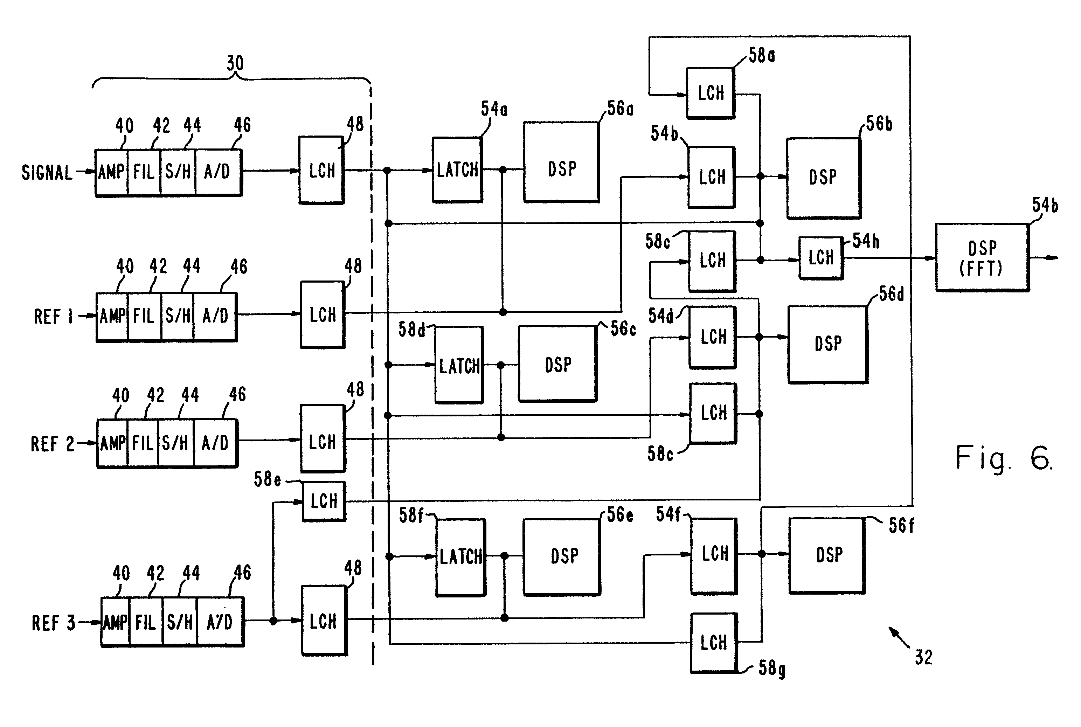

Figs. 6, 7 and 8 illustrate a four channel (a signal channel and 3 reference channels) adaptive canceler 32 of the embodiment of the adaptive analysis apparatus discussed hereinbefore. Referring to Fig. 6, the outputs of the buffer latches 48 of each channel (signal and references 1-3) of the signal conditioning circuit 30 are coupled to the adaptive filter 32 which comprises a plurality of input latches 54a, 54b, 54d, and 54f, six digital signal processor (DSP) circuits 56a-56f, seven pipeline latches 58a-58g, and an output latch 54h. The processor circuits used in this embodiment are Texas Instruments model TMS 320C25 Digital Signal Processor and the latches 54 and 58 are Texas Instruments model 74ALS244. The wiring and interconnection of these circuits are generally well-known in the art and will not be discussed in detail. Application notes from the manufacturer are available that describe the wiring and operation of these circuits.

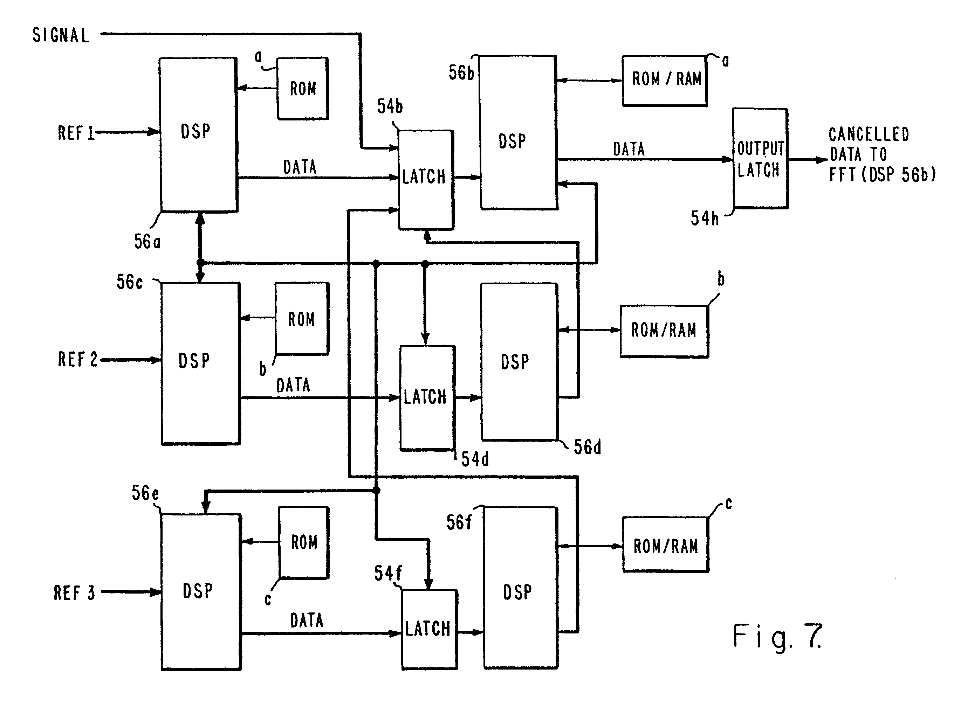

Fig. 7 illustrates the data path in the embodiment of a four channel LMS adaptive filter used in the architecture of the present invention. Data from the primary sensor (SIGNAL) is coupled by way of latch 54b to the second digital signal processor 56b. Data from the first, second and third reference sensors are coupled to the first, third and fifth processors 56a, 56c, 56e, respectively. Data processed by the first, third and fifth processors 56a, 56c, 56e are coupled by way of latches 54b, 54d, 54f to the second, fourth and sixth processors 56b, 56d, 56f. The first and second processors 56a, 56b implement the Least Means Square adaptive filter having distributed weights. In particular, the first processor 56a processes the first 200 weights, while the second processor 56b processes the second 200 weights. Similarly, the third and fourth processors 56c, 56d, and the fifth and sixth processors 56e, 56f implement least means square adaptive filters having distributed weights, respectively. Additionally, the second processor 56b combines the primary signal with the adaptively-filtered noise signals processed by the adaptive filters and generates coefficient update terms for each of the adaptive processors 56a-56f. In particular, the second processor 56b computes the expression

$$\epsilon = d(n) - \sum_{k=1}^{m} W(k) x(n-k)$$

and generates weight update factors which are defined by the expression $W(k+1) = W(k) + 2\mu\epsilon x(n-k)$. Coefficient update terms are provided from the second processor to each of the other processors 56a, 56c-56f along the data path indicated in Fig. 7. The random access memory (RAM) and the read only memory (ROM) blocks in Fig. 7 indicate the instructions for implementing the LMS filter algorithm in the DSP's 56a-56f according to the programming instructional language of the devices.

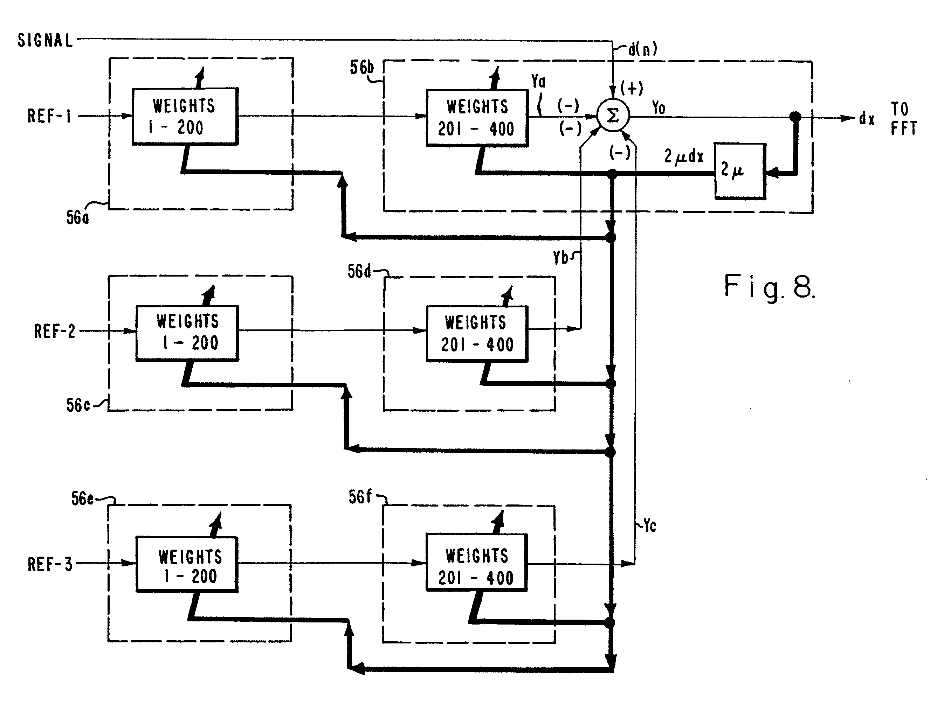

Fig. 8 is a diagram illustrating the distributed architecture of the four channel adaptive filter of the embodiment discussed herein. The computations performed by the six processors 56a-56f are defined by the following equations. $Y_a = R_1 + R_2$, $Y_b = R_3 + R_4$, and $Y_c = R_5 + R_6$, where $R_1$ is the partial weight result produced by the first stage processor 56a, $R_2$ is the partial weight result produced by the second stage processor 56b, $R_3$ is the partial weight result produced by the first stage processor 56c, $R_4$ is the partial weight result produced by the second stage processor 56d, $R_5$ is the partial weight result produced by the first stage processor 56e, and $R_6$ is the partial weight result produced by the second stage processor 56f, and where

$$R_1 = \frac{1}{2^{16}} \sum_{k=1}^{200} W(k) x(n)_{1k} + 8000H$$

$$R_2 = \frac{1}{2^{16}} \sum_{k=201}^{400} W(k)x(n)_{1k} + 8000H$$

$$R_3 = \frac{1}{2^{16}} \sum_{k=1}^{200} W(k)x(n)_{2k} + 8000H$$

$$R_4 = \frac{1}{2^{16}} \sum_{k=201}^{400} W(k)x(n)_{2k} + 8000H$$

$$R_5 = \frac{1}{2^{16}} \sum_{k=1}^{200} W(k)x(n)_{3k} + 8000H$$

$$R_6 = \frac{1}{2^{16}} \sum_{k=1}^{400} W(k)x(n)_{3k} + 8000H$$

and 8000H (Hex) is a round off factor equal to one half the least significant bit.

$Y_0 = 4(Y_a + Y_b + Y_c)$, where the factor 4 is a scaling factor.

$\epsilon = d(n) - Y_0$, which comprises the error, and

$\mu_\epsilon = (2\mu_\epsilon + 8000H)/2^{16}$, which produces a 16 bit normalization of the error and where $\mu$ is equal to 1000 Hex.

More particularly, the multi-channel adaptive filter computes the partial value $R_1$ in processor 56a, carries this value and the 200th sample data to processor 56b, computes the partial value $R_2$ and provides the resultant $Y_a$ to the summing junction. A similar process is followed for the calculation of partial sum $R_2$ in processor 56c, partial $R_2$ in processor 56d, and the calculation of $Y_b$. The calculation of partial $R_2$ in processor 56e and partial $R_2$ in processor 56f follow the same process to produce the resultant $Y_c$. The resultants are summed in the second processor 56b as indicated in Fig. 8. The effective error term is then multiplied by 21, and used to update the weight coefficients of the filter based on the nature of the undesired ambient energy that is being filtered from the primary signals. A digital process delay equal to approximately one-half the delay through the total taps (a delay equal to the delay through taps 1-200 in this case) is included in the primary channel only, to assure convergence to the ideal Wiener solution.

Although 400 taps were shown in this embodiment, this is not meant to be restrictive of the invention. More or fewer taps may be used depending upon the particular application.

Fig. 9 is a diagram illustrating a central processing unit 36 usable in the adaptive analysis apparatus 10.

The computational portion of the apparatus 10 of this embodiment includes a primary processing unit 60 and a coprocessor 61 which, for this embodiment, is an Intel model 80186 processor and a an Intel model 8087 coprocessor, respectively. A system bus 62 is employed to interconnect the components comprising the central processing unit 36. A random access memory 64 and an erasable, programmable read-only memory 66 are coupled to the primary processing unit 60 by way of the bus 62. Various interfaces are provided which include a user interface 68 which couples the central processing unit 60 to a key pad 70 and a display device 72. Also shown are a C bus interface 74 which is employed to interface to the external computer, a D bus digital signal processor interface 76 employed to interface between the digital signal processors 56a-56f and the central processing unit 36, and a serial communications interface 78 which is an RS-232 serial port in this embodiment. Additionally, for the purposes of monitoring and analyzing machinery having rotating components, two rotational sensors are coupled by way of two amplifiers 80, 82 and two counters 84, 86 which are Intel model 8254 integrated circuits to the bus 62 in order to provide rotational data which is used to initiate data acquisition and analysis as a reference for order analysis.

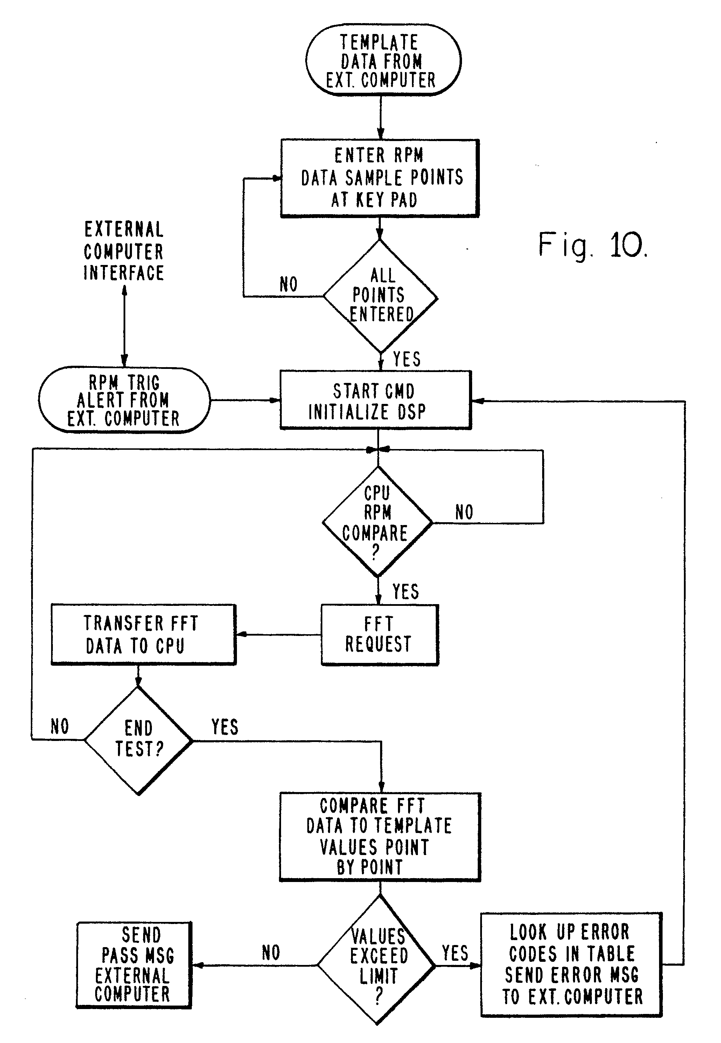

Fig. 10 illustrates a high level process flowchart implemented in the central processing unit 36 of Fig. 9. The process flow comprises the following steps. Template data is loaded into either the random access memory 64 or the read only memory 66 from the external computer. An operator enters RPM sample points by way of the keypad 70 to indicate to the adaptive analysis apparatus 10 at which rotational rate data is to be analyzed. The central processing unit 60 compares the RPM of the machinery under test to the selected RPM entered by the operator, and once a selected RPM is reached, a Fourier transform data request is made. The adaptive canceler 32 provides canceled signal data on a continuous basis, and once the correct RPM has been reached, the central processing unit 60 initiates the transfer of the data over the D bus interface. The central processing unit 36 then compares the sampled data to the templates stored in the random access memory 64 or read only memory 66 on a point by point basis with the calculations typically being performed in the co-processor 61. If a predetermined number of the data points exceed the thresholds in a selected template at a specified RPM frame, a selected error code is provided to the operator indicating an error code of the potential problem. If no thresholds were exceeded, then a pass message is transferred to the external computer.

A brief discussion of the processing capabilities of an actually constructed embodiment will illustrate the usefulness of the adaptive analysis apparatus. The constructed apparatus is a four channel device (one signal channel and 3 reference channels) and has a system sample rate of 20,000 Hz per channel. The adaptive canceler implements the LMS algorithm having 400 fixed taps, a variable convergence factor, a primary channel delay equivalent to 200 taps, and a basic processing rate of $100 \times 10^{-6}$ seconds (the DSP processing rate). This provides a throughput of 1024-point complex FFT at a rate of 10 FFT's per second with no FFT overlap. With a 50 percent overlap, the apparatus provides 1024-point complex FFT at a rate of 20 FFT per second. This results in a digital spectrum for analysis approximately every 50 milliseconds. The apparatus can be expanded to include more channels and more taps while maintaining approximately the same throughput through the use of the distributed architecture described hereinbefore for the adaptive canceler section 34.

It will be apparent that the adaptive analysis apparatus has numerous applications. The apparatus has been described in connection with assembly line quality-control testing of automotive transmissions. However, the apparatus is useful in quality control testing or analysis of any device having an acoustic signature which is related in some manner to the present or prospective operability of the device. The apparatus may be used in analyzing the acoustic signatures of defective devices to determine the exact defect or as a preventive maintenance tool to periodically monitor a device to identify present or prospective problems. The apparatus can be employed to continuously monitor the acoustic signature of an operating device, or a critical component in a device, to indicate any relevant change in the acoustic signature and provide a signal indicating a possible problem or hazard. The apparatus can be used as a passive acoustic signal detector in the presence of contaminating noise in a manner similar to a passive radar receiver by continuously canceling the noise from the signal channel so that the appearance of new acoustic data in the signal channel will be immediately detected and comparatively analyzed against predetermined reference data. The ability to both adaptively process large amounts of acoustical information and analyze the acoustical information in real-time provided by the present invention is applicable to almost any situation where valuable information is contained in an acoustical signal of interest.

It is to be understood that the above-described embodiments are merely illustrative of some of the many embodiments which represent applications of the principles of the present invention. Other arrangements can be readily devised by those skilled in the art without departing from the scope of the invention and the invention is meant to include such arrangements unless specifically limited by the claims.

**Claims**

1. An adaptive analysis apparatus comprising:
- primary signal sensor means (26) for receiving a primary signal comprising a signal of interest generated by a device of interest (12) and also comprising a noise component;
- at least one reference sensor means (20, 22, 24) for receiving noise signals;
- adaptive canceler means (32) coupled to said primary and at least one reference sensor means (20, 22, 24, 26) for adaptively combining said noise signals with said primary signal to provide a noise canceled signal in which the noise component of said primary signal has been reduced thereby improving the signal-to-noise ratio thereof,
characterized by:
- predetermined reference data (66, 68, 70, 72) pertaining to at least one characteristic of the device of interest (12); and
- computational means (36) for analyzing the noise canceled signal by comparing said noise canceled signal to said predetermined reference data and for providing an output signal indicative of the results of said comparison.

2. The adaptive analysis apparatus of claim 1, characterized in that the noise component of the primary signal is uncorrelated with the signal of interest but is correlated with the noise signals received by said at least one reference sensor means (20, 22, 24).

3. The adaptive analysis apparatus of claim 1 or 2, characterized in that said adaptive canceler means (32) comprises a first digital adaptive filter and at least one other digital adaptive filter coupled in series to provide concurrent distributed cancellation, the first of said digital adaptive filters performing a first number of weight adjustments to provide a first output signal, said at least one other of the digital adaptive filters receiving said first output signal and performing a second number of weight adjustments to provide said noise canceled signal which is a signal having been adaptively weighted the first and the second number of times.

4. The adaptive analysis apparatus of any of claims 1 through 3, characterized in that said predetermined reference data (66, 68, 70, 72) is formed into a template which is indicative of a predefined condition of said device of interest (12).

5. The adaptive analysis apparatus of claim 4, characterized in that said template comprises a threshold that is indicative of an unacceptable device of interest (12).

6. The adaptive analysis apparatus of any of claims 1 through 5, characterized by:
- operation sensor means (80, 82, 84, 86) for indicating the current operational state of the device of interest (12); and
- wherein said predetermined reference data (66, 68, 70, 72) pertains to at least one characteristic of the device of interest (12) at a predetermined operational state; and
- wherein said computational means (36) is for analyzing said noise canceled signal only when said operational sensor means (80, 82, 84, 86) indicates that said device of interest (12) is at said predetermined operational state.

7. The adaptive analysis apparatus of any of claims 1 through 6, characterized in that:
- the predetermined reference data (66, 68, 70, 72) was derived from the analysis of at least one reference device having known characteristics; and
- said computational means (36) is for comparing said noise canceled signal with said predetermined reference data (66, 68, 70, 72) and analyzing said comparison results on a statistical basis and for providing an output signal indicative of the statistical comparison.

8. The adaptive analysis apparatus of claim 7, characterized in that said at least one reference device of interest having known characteristics was analyzed to generate said predetermined reference data (66, 68, 70, 72) under noise conditions substantially identical to the noise conditions under which the device of interest (12) is analyzed.

9. The adaptive analysis apparatus of any of claims 1 through 8, characterized in that said predetermined reference data (66, 68, 70, 72) comprises a statistical analysis of operational data pertaining to said predetermined reference data (66, 68, 70, 72) to establish the average performance and at least one multiple of the standard deviation on either side of said average.

10. The adaptive analysis apparatus of any of claims 3 through 9, characterized in that:
- said computational means (36) comprises controller means for applying a first set of signals from said primary signal sensor means (26) and said at least one reference sensor means (20, 22, 24) to said adaptive canceler means (32); and
- said controller means also for applying a second set of signals from said primary signal sensor means (26) and said at least one reference sensor means (20, 22, 24) to said adaptive canceler means (32) after said first set of signals has been processed and outputted by said first of said digital adaptive filters such that concurrent, distributed processing of signals occurs in said adaptive canceler means (32).

Fig. 1.

EP 0 399 386 A2

2405P243EP

Fig. 2.

Fig. 3.

EP 0 399 386 A2

Fig. 4.

EP 0 399 386 A2

2405P243EP

# Fig. 5.

Fig. 6.

EP 0 399 386 A2

Fig. 7.

EP 0 399 386 A2

2405P243EP

Fig. 8.

EP 0 399 386 A2

EP 0 399 386 A2

2405P243EP

Fig. 9.

EP 0 399 386 A2

Fig. 10.

2405P243EP